# DEMANDE DE BREVET EUROPEEN

(11) **EP 0 635 378 A2**
(43) Date de publication de la demande: **25.01.1995**
(21) Numéro de dépôt: 94401651.8
(22) Date de dépôt: 19.07.1994
(51) Int. Cl.: B41M 1/00, G03F 5/00, B41M 1/04

(54) **Forme d'impression pour procédé d'impression typographique et utilisation de la forme pour l'impression sur des surfaces dures non absorbantes**

(30) Priorité: 22.07.1993 DE 4324577
(71) Demandeur: SAINT-GOBAIN VITRAGE, F-92400 Courbevoie (FR)
(72) Inventeur: Häussler, Günther, D-52062 Aachen (DE); van der Meulen, Rolf, D-52134 Herzogenrath (DE); Hars, Christoph, D-33619 Bielefeld (DE); Sonnenschein, Joachim, D-64367 Mühltal (DE)
(74) Mandataire: Muller, René

(57) **Abrégé**

Pour l'impression de matières à imprimer dures formées d'un matériau non absorbant, en particulier pour l'impression de feuilles de verre (18), on propose le recours au procédé flexographique. A cet effet, on utilise une forme d'impression (3) faite d'une plaque de photopolymère qui présente une image imprimante tramée comportant une fine trame superposée à la trame de fond ou de motif. La forme d'impression (3) est constituée d'une feuille de stabilisation (30) et de la couche de photopolymère (31) munie de la trame. Une plaque (33), en matière expansée, est intercalée entre la forme d'impression (3) et le corps du cylindre porte-cliché (4). L'invention permet, lors de l'impression de surfaces dures non absorbantes, un transfert uniforme et plus régulier de l'encre à l'intérieur de chaque point d'impression particulier.

## Description

La présente invention concerne la réalisation d'une forme d'impression destinée à un procédé d'impression typographique rotatif. Elle concerne, en outre, l'utilisation d'une telle forme d'impression dans un procédé flexographique pour l'impression sur des matières à imprimer formées d'un matériau dur non absorbant ou peu absorbant et notamment pour l'impression sur du verre, sur certaines matières plastiques telles que le chlorure de polyvinyle (PVC), sur des matériaux métalliques, etc...

Dans les procédés d'impression typographique rotatifs, le transfert de l'encre sur la matière à imprimer se fait directement au moyen de la forme d'impression qui est également appelée cliché et, en particulier, au moyen des parties en relief de la forme d'impression. La forme d'impression est, en l'occurrence, façonnée sous forme de plaque d'impression et est tendue sur la surface d'enveloppe du cylindre porte-cliché. Lors de l'impression d'un motif ou d'une image, le motif d'impression est réalisé sous la forme d'une trame dont les points d'impression en relief constituent des surfaces d'impression unies sur lesquelles l'encre adhère et à partir desquelles l'encre est transférée sur la matière à imprimer.

Lors du transfert de l'encre, à partir des points d'impression en relief du cliché sur la matière à imprimer, la colonne d'encre est divisée sur les points d'impression. Suivant le caractère absorbant de la matière à imprimer et en fonction des propriétés physiques de l'encre, une quantité déterminée d'encre est transférée sur la matière à imprimer, tandis qu'une partie de l'encre reste collée sur les points d'impression du cliché. Le rapport de la quantité d'encre transférée sur la matière à imprimer à la quantité d'encre présentée par le cliché est habituellement exprimé par l'indice dit d'encrage. Ce rapport est très défavorable avec des matières à imprimer très lisses et non ou peu absorbantes, par exemple avec les surfaces en verre, les surfaces en PVC, les surfaces métalliques, etc... Cela signifie que seule une quantité insuffisante d'encre est transférée sur de telles matières à imprimer, ce qui conduit à une intensité insuffisante de la couche d'encre.

Une autre difficulté lors de l'impression de matières à imprimer non ou peu absorbantes, qui est particulièrement marquée dans un procédé d'impression typographique rotatif consiste en une répartition non homogène de l'encre dans chaque point imprimé à partir des points d'impression en relief de la forme d'impression. En raison du processus de roulement de la forme d'impression sur la matière à imprimer, l'encre est « expulsée » de chaque point d'impression, toujours au niveau du bord arrière, de sorte que l'encre est concentrée principalement au milieu et au bord arrière (bourrelet d'encre) des points imprimés sur la matière à imprimer. Avec un matériau transparent tel que du verre ou du polyméthylméthacrylate (PMMA) comme matière à imprimer, s'ajoute l'inconvénient que cette répartition non homogène de l'encre se remarque particulièrement bien en transparence.

L'invention a notamment pour but de réaliser une forme d'impression destinée à un procédé d'impression typographique rotatif, ladite forme conduisant, même lors de l'impression d'une matière à imprimer formée d'un matériau non ou peu absorbant, à une image à imprimer propre avec une quantité suffisante d'encre et une répartition régulière de l'encre dans chaque point imprimé sur ladite matière à imprimer.

Conformément à l'invention, ce but est atteint à l'aide d'une forme d'impression dans laquelle les points d'impression transférant l'encre de la trame de fond formant le motif sont recouverts par une trame plus fine.

Dans un mode de réalisation préféré de la forme d'impression selon l'invention, les points d'impression transférant l'encre de la trame de fond formant le motif, comptant 4 à 40 lignes par cm et ayant une couverture du point de 3 à 100 % sont ainsi recouverts par une trame fine comptant 50 à 150 lignes par cm et, de façon particulièrement préférée, 50 à 120 lignes par cm, et ayant une couverture du point de 5 à 60 % et, de façon particulièrement préférée, de 5 à 50 %.

Une trame est, comme on le sait, définie sans ambiguïté par le nombre de lignes par cm, appelé aussi "indice de trame" et par la couverture du point en %. Par « point », « point d'impression » ou « point imprimé » selon l'invention, il convient d'entendre non seulement une surface d'impression ou une surface imprimée de forme circulaire, mais également une surface d'impression ou une surface imprimée de forme différente, notamment une surface de forme géométrique, par exemple de forme triangulaire, etc... Du fait que les divers points ou surfaces d'impression de la forme d'impression sont disposés en lignes, on parle habituellement de lignes par cm. L'indice de trame indique donc l'écartement ou la distance des points ou surfaces d'impression, c'est-à-dire la distance entre les centres de deux points ou surfaces d'impression consécutifs d'une même ligne. La grosseur du point est déterminée par la couverture du point en %. La couverture du point en % est le rapport des surfaces des points d'impression à la surface totale du motif tramé.

La forme d'impression selon l'invention présente plusieurs avantages. D'une part, par le tramage fin superposé des points d'impression de la forme d'impression, on obtient que de plus grandes quantités d'encre soient transférées sur la matière à imprimer du fait que la surface des points d'impression de la trame de fond est augmentée de cette façon et donc qu'une plus grande quantité d'encre adhère aux points de trame de la trame de fond. D'autre part, il s'est révélé en particulier qu'avec une trame superposée conformément à l'invention, une répartition uniforme et homogène de l'encre est obtenue dans chaque point imprimé à partir des points d'impression de la trame de fond.

Un avantage particulier est offert par l'utilisation d'une forme d'impression réalisée conformément à l'invention dans le procédé flexographique, lorsque ce procédé doit être appliqué à l'impression de surfaces dures non ou peu absorbantes telles que mentionnées précédemment. Le procédé flexographique convient fondamentalement pour l'impression de matériaux durs, comme les feuilles de verre, de PVC ou les feuilles de métal parce que la forme d'impression consiste en un ou des matériaux relativement mous, à savoir, par exemple, du caoutchouc et/ou une matière plastique. Habituellement, la forme d'impression consiste, en l'occurrence, en une plaque de photopolymère sur laquelle l'image est formée par voie photochimique. Dans ce cas, un polymère photosensible est exposé à de la lumière U.V. à travers un film portant la trame choisie, de sorte que les parties exposées durcissent. Les parties non exposées sont ensuite éliminées par dissolution. Cette technique pour la confection des planches d'impression faites d'un photopolymère est également appelée « technique de développement » ou, de façon plus large, « technique de photogravure ». Il s'est révélé que cette technique convient, dans une mesure particulière, pour la confection de formes d'impression suivant l'invention et que des résultats particulièrement bons, lors de l'impression des surfaces dures non ou peu absorbantes telles que des surfaces de verre, peuvent être obtenus à l'aide du procédé flexographique en utilisant de telles formes d'impression.

D'autres particularités et avantages de l'invention ressortent de la description d'un exemple de réalisation préféré donnée ci-après avec référence aux dessins.

Dans les dessins, toujours de forme schématique :
· la figure 1 représente une presse à imprimer pour l'exécution du procédé flexographique,
· la figure 2 illustre le mode d'action d'une forme d'impression tramée conforme à l'état connu de la technique,
· la figure 3 illustre le mode d'action d'une forme d'impression tramée conforme à l'invention,
· la figure 4 illustre la confection d'une plaque de photopolymère conforme à l'invention.

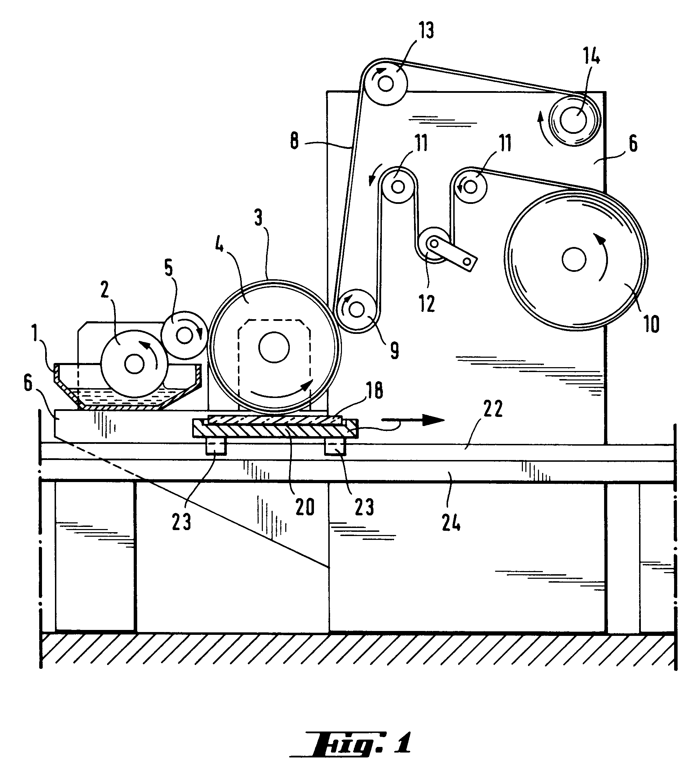

Les particularités de construction essentielles d'une machine flexographique conforme à l'invention, qui se prête à l'impression, par exemple, de feuilles de verre, sont représentées schématiquement à la figure 1. La presse proprement dite comprend un encrier 1 contenant l'encre, un rouleau barboteur 2 enfoncé dans l'encre, un cylindre porte-cliché 4 portant la forme imprimante ou cliché 3 et un rouleau encreur tramé 5 qui, à son tour, transfère l'encre du rouleau barboteur 2 à la forme d'impression 3. Le rouleau barboteur 2, le cylindre porte-cliché 4 et le rouleau encreur tramé 5 sont montés, de la façon habituelle, sur un bâti de machine 6 et entraînés, de façon synchrone, par un mécanisme non représenté aux dessins.

Derrière le cylindre porte-cliché 4, le bâti de machine 6, porte un dispositif au moyen duquel le résidu d'encre adhérant à la forme d'impression après le processus d'impression est éliminé de la forme d'impression. L'enlèvement de ce résidu d'encre peut se faire à l'aide d'un rouleau collecteur d'encre, à l'aide d'une nappe de matière absorbante, etc... et se fait, selon la figure 1, au moyen d'une nappe 8 de matière à imprimer absorbante, par exemple, de papier, qui est pressée par un rouleau 9 contre le cylindre porte-cliché 4. La nappe de papier 8 est dévidée d'un rouleau d'alimentation 10, passe sur deux rouleaux de renvoi 11 entre lesquels elle est maintenue tendue par un rouleau valseur 12 et après contact avec le cylindre porte-cliché 4, elle est à nouveau enroulée sur un rouleau 14 en passant sur un rouleau de renvoi 13.

Tandis qu'avec les machines flexographiques connues, les matières à imprimer sont, en règle générale, imprimées sous forme de nappes flexibles qui sont pressées contre le cylindre porte-cliché par un cylindre d'appui, la machine d'impression conforme à l'invention nécessite un système de transport au moyen duquel les feuilles de verre 18 à imprimer sont acheminées au cylindre porte-cliché 4. Un tel système de transport peut consister, par exemple, en un système à courroie ou bande de transport. En cas d'exigences accrues en matière de qualité d'impression, en particulier pour l'impression multiple, on utilise cependant, de préférence, un système de transport à chariot en raison des exigences élevées imposées à la précision de positionnement.

Un tel système de transport à chariot comprend un chariot mobile 20, sur lequel la feuille de verre 18 est positionnée en un endroit défini avec précision et est maintenue dans cette position. Le positionnement de la feuille de verre 18 sur le chariot 20 est assuré, par exemple, par des broches ou des lattes de guidage mécaniques. Ces dispositifs de positionnement sont en eux-mêmes connus et ne sont pas représentés aux dessins par souci de clarté. Après le positionnement de la feuille de verre 18 sur le chariot 20, la feuille de verre 18 est fixée au moyen d'un système à dépression approprié sur la surface d'appui du chariot 20. De tels dispositifs à dépression pour la fixation des feuilles de verre sont également connus et ne sont pas représentés aux dessins.

Le chariot 20 est, en outre, muni d'un dispositif de réglage en hauteur également non représenté. A l'aide de ce dispositif de réglage en hauteur, la position en hauteur du chariot 20 peut être réglée en fonction de l'épaisseur de la feuille de verre 18 à imprimer et la pression d'application de la feuille de verre sur le cylindre de porte-cliché peut être modifiée.

Le chariot 20 est monté sur des rails 22, par exemple à l'aide de paliers linéaires 23. Les rails 22 sont montés sur des supports stables 24. Le chariot 20 est muni d'un système d'entraînement approprié qui est synchronisé avec l'entraînement des rouleaux de la presse à imprimer. Le système d'entraînement et la synchronisation du chariot peuvent en principe être réalisés de diverses façons à l'aide de moyens habituels et connus.

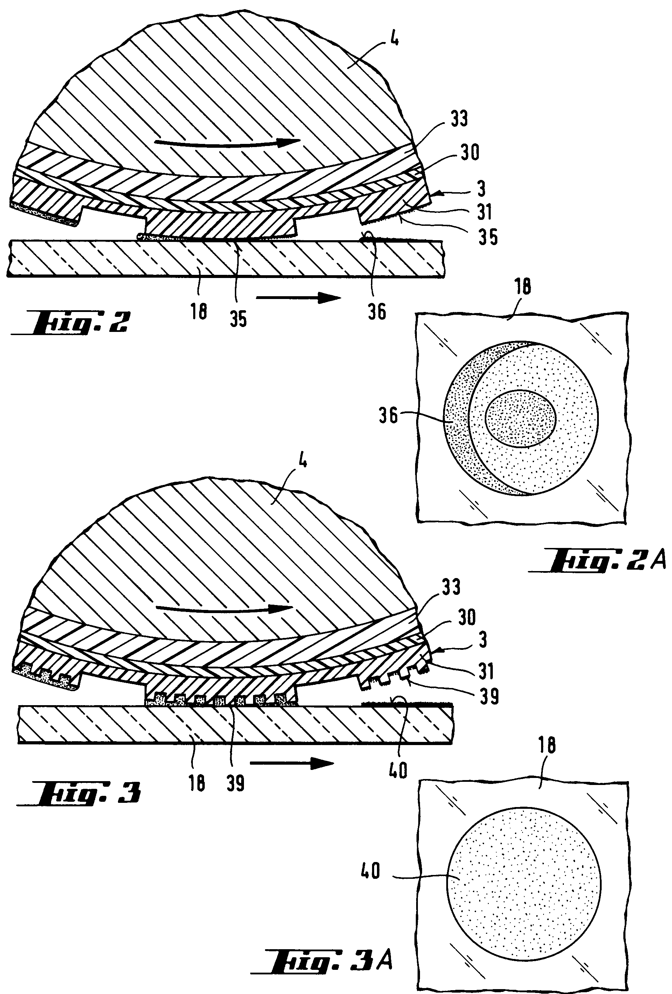

La forme d'impression 3 utilisée pour le procédé flexographique présente, comme cela ressort des figures 2 à 4, en principe une structure en deux couches et consiste en une feuille de stabilisation 30 et en une couche 31 d'un photopolymère appliqué par-dessus. Pour compenser d'éventuelles irrégularités de la surface de la feuille de verre 18 à imprimer, du cliché 3 et du cylindre porte-cliché 4, une couche intermédiaire 33 d'une épaisseur d'environ 0,5 à 2,5 mm formée d'une matière expansée appropriée est interposée entre la forme imprimante 3 et le corps de cylindre 4.

Les figures 2 et 2A montrent schématiquement, à une échelle nettement plus grande, comment le transfert de l'encre se fait à l'aide d'un point de trame 35 dans le cas d'une forme imprimante conforme à l'état de la technique. Pour le point de trame 35, il s'agit, par exemple, d'une surface en relief circulaire d'une trame n° 16, c'est-à-dire d'une trame ponctuelle de 16 points par cm, ainsi que d'une couverture du point de 60 %. La surface de ce point de trame 35 qui transfère l'encre sur la feuille de verre 18 est représentée unie. Pendant le processus de roulement, représenté à la figure 2, de la surface unie du point d'impression sur la feuille de verre 18, l'encre est expulsée au bord latéral et au bord arrière du point d'impression. En conséquence, l'encre se répartit sur la surface du verre de la façon observable à la figure 2A, c'est-à-dire qu'il se forme une surface d'encre 36 en demi-lune concentrée (bourrelet d'encre). Dans la surface restante, l'encre est répartie de façon stochastique avec une légère accumulation au milieu.

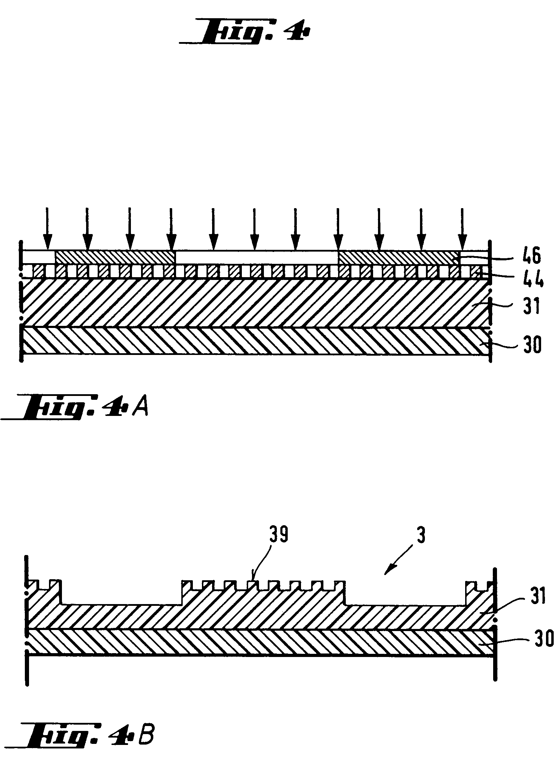

Les figures 3 et 3A montrent, au contraire, également à plus grande échelle et schématiquement, la configuration d'un point d'impression 39 d'une forme d'impression selon l'invention et la surface d'encre 40 ainsi obtenue sur la feuille de verre 18. Dans ce cas également, la forme d'impression 3 comprend à nouveau une feuille de stabilisation 30 et la couche de photopolymère 31 portant la trame d'impression conforme à l'invention. Entre la forme d'impression 3 et la surface du corps du cylindre porte-cliché 4 est à nouveau interposée une feuille d'adhérence expansée élastique 33 qui compense les irrégularités de surface éventuelles. L'image qu'il faut imprimer est à nouveau tramée, par exemple en utilisant à nouveau une trame n° 16 ayant une couverture du point de 60 %. Le point d'impression 39 correspond donc par ses dimensions au point d'impression 35 de la figure 2. La surface du point d'impression 39 est cependant, à son tour, munie d'une fine trame ponctuelle, par exemple d'une trame de 60 à 80 points par cm. La couverture du point de cette trame ponctuelle fine s'élève par exemple à 40 % sur la base de la surface totale du motif d'impression tramé.

Grâce à la trame fine superposée aux points d'impression de la trame de fond, la surface des points d'impression de la trame de fond est augmentée en proportion, de sorte qu'une plus grande quantité d'encre y adhère. La quantité d'encre présentée par le rouleau encreur est tellement grande qu'elle remplit complètement la trame fine superposée, c'est-à-dire qu'à la différence des procédés d'impression typographique habituellement utilisés, l'encre se trouve non seulement sur les parties en relief, mais également dans des espaces intermédiaires des points d'impression. Il en résulte un transfert d'encre plus important et dans l'ensemble plus uniforme, comme le montre la figure 3A. L'encre dans les espaces intermédiaires de la trame superposée de la surface d'impression n'est pas expulsée lors du processus de roulement et en plus de la quantité d'encre transférée aux points en relief de la trame superposée, un transfert d'encre a également lieu par les colonnes d'encre dans les espaces intermédiaires. Il se forme, de la sorte, une couche d'encre 40 uniforme, fermée et plus épaisse dont les dimensions en surface correspondent au point d'impression 39.

Le procédé de fabrication d'une forme d'impression conforme à l'invention à partir du photopolymère par voie photochimique est expliqué ci-après avec référence à la figure 4. Le matériau de départ pour la forme d'impression proprement dite consiste en une couche 31 formée d'un photopolymère photosensible qui est durci par irradiation avec de la lumière U.V., appliquée sur une feuille de stabilisation 30.

On réalise la trame superposée en appliquant l'un sur l'autre, d'abord un film négatif 44 pour la trame fine, par exemple une trame n° 70, puis un film négatif 46 pour la trame de motif ou de fond, par exemple une trame n° 16, sur le film de photopolymère 31 et en les exposant simultanément (figure 4A). Aux endroits où les rayonnements U.V. atteignent la couche de photopolymère 31 à travers les régions transparentes des négatifs, la couche de photopolymère 31 durcit en surface. Après enlèvement des négatifs 44 et 46, la couche de photopolymère 31 est traitée à l'aide d'un liquide au moyen duquel les régions de polymère non exposées et donc non durcies sont éliminées par dissolution.

On obtient, de cette façon, la forme d'impression représentée à la figure 4B comprenant une trame superposée, qui, telle quelle, éventuellement après un traitement de durcissement supplémentaire, est tendue comme cliché sur le corps de cylindre du cylindre porte-cliché.

A l'aide du procédé décrit, il est possible, par exemple, d'imprimer des couches de protection solaire tramées, faites d'une encre à cuire telle qu'un émail, sur des feuilles de verre utilisées comme toit transparent dans les véhicules automobiles. A cet effet, on superpose, par exemple, à une trame de fond de 16 lignes par cm et d'une couverture du point de 30 %, une trame fine de 70 lignes par cm et d'une couverture du point de 50 %.

Pour un autre cas d'application, à savoir l'impression d'un cadre décoratif noir opaque formé d'une encre à cuire telle qu'un émail, qui est, en règle générale, nécessaire pour les vitrages automobiles qui sont fixés par collage dans l'encadrement de fenêtre de la carrosserie d'automobile, on superpose, par exemple, à une trame de fond de 12 à 16 lignes par cm et d'une couverture du point de 97 %, une trame fine de 120 lignes par cm et d'une couverture du point de 50 %.

## Revendications

1. Forme d'impression pour un procédé d'impression typographique rotatif, caractérisée en ce que les points d'impression transférant l'encre de la trame de fond formant le motif sont recouverts par une trame plus fine.

2. Forme d'impression selon la revendication 1, caractérisée en ce que les points d'impression de la trame de fond comptant 4 à 40 lignes par cm et ayant une couverture du point de 3 à 100 % sont recouverts par une trame fine comptant 50 à 150 lignes par cm et ayant une couverture du point de 5 à 60 %.

3. Forme d'impression selon l'une des revendications 1 ou 2, caractérisée en ce qu'elle est constituée d'un ou plusieurs matériaux mous tels que le caoutchouc et/ou une matière plastique.

4. Forme d'impression selon l'une des revendications 1 à 3, caractérisée en ce qu'elle comprend une couche (31) d'un photopolymère munie de la trame de fond.

5. Forme d'impression selon la revendication 4, caractérisée en ce qu'elle comprend en outre une feuille de stabilisation (30).

6. Utilisation d'une forme d'impression selon l'une des revendications 1 à 5 dans un procédé pour l'impression de matières à imprimer formées d'un matériau dur non ou peu absorbant.

7. Utilisation d'une forme d'impression selon l'une des revendications 3 à 5 dans un procédé flexographique pour l'impression de matières à imprimer formées d'un matériau dur non ou peu absorbant.

8. Utilisation selon l'une des revendications 6 ou 7 pour l'impression de la surface d'une feuille de verre.

9. Utilisation selon l'une des revendications 6 à 8, caractérisée en ce qu'une couche intermédiaire (33) souple élastiquement, déformable, est interposée entre la forme d'impression (3) et le cylindre porte-cliché (4) portant la forme d'impression, en vue de la compensation des irrégularités de surface de ladite forme, dudit cylindre porte-cliché et de la feuille à imprimer.

10. Utilisation selon l'une des revendications 6 à 9, caractérisée en ce que les feuilles à imprimer (18) sont acheminées au cylindre porte-cliché (4) par I'intermédiaire d'un système à courroie ou bande de transport ou par l'intermédiaire d'un système de transport à chariot.

11. Procédé de réalisation d'une forme selon l'une des revendications 4 ou 5 suivant la technique de développement, caractérisé en ce qu'un film portant une trame fine et un film portant une trame de fond contenant le motif sont superposés sur la couche de photopolymère devant former la forme d'impression et ladite couche de photopolymère portant les deux films superposés est exposée à un rayonnement U.V., les parties de la couche de photopolymère non exposées et donc non durcies étant éliminées par dissolution.
